(19) **Europäisches Patentamt** / **European Patent Office** / **Office européen des brevets**

(11) **EP 4 401 489 A1**

(12) **EUROPEAN PATENT APPLICATION**
published in accordance with Art. 153(4) EPC

(43) Date of publication:
**17.07.2024 Bulletin 2024/29**

(21) Application number: **22877893.2**

(22) Date of filing: **28.09.2022**

(51) International Patent Classification (IPC):
***H04W 72/04*** *(2023.01)*

(52) Cooperative Patent Classification (CPC):
**H04L 1/00; H04W 72/04**

(86) International application number:
**PCT/CN2022/122236**

(87) International publication number:
**WO 2023/056874 (13.04.2023 Gazette 2023/15)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.10.2021 CN 202111172151**

(71) Applicant: **Sanechips Technology Co., Ltd.**
**Shenzhen, Guangdong 518055 (CN)**

(72) Inventor: **GAO, Guoyu**
**Shenzhen, Guangdong 518057 (CN)**

(74) Representative: **Brunazzi, Stefano**
**Jacobacci & Partners S.p.A.**
**Via Senato, 8**
**20121 Milano (IT)**

(54) **DOWNLINK CONTROL CHANNEL DECODING METHOD AND DEVICE, STORAGE MEDIUM AND ELECTRONIC DEVICE**

(57)     Provided in embodiments of the invention are a method and apparatus for decoding a downlink control channel, a storage medium, and an electronic apparatus. The method includes: dividing a resource in a blind detection and decoding process of a physical downlink control channel (PDCCH) into multiple portions of resources; invoking one or more portions of resources for a plurality of channels set according to a resource configuration individually, and performing blind detection on data received through the one or more portions of resources; and invoking one or more PDCCH decoders occupied by the channels to decode candidate decoding data corresponding to the blind detection. Accordingly, the problem that decoding performance may be reduced in scenarios involving a plurality of control-resource-sets (CORESETs) and repeated blind detection initiation through a method for controlling a PDCCH nested decoding flow in the related art can be solved, and a resource amount invoked can be flexibly configured. Moreover, the channels occupied by all carriers can be flexibly configured, and carriers having a large data transmission amount and requiring more resources can be allocated to channels capable of invoking more resources.

Fig. 3

**Description**

**Cross-Reference to Related Application**

The invention is based on Chinese Patent Application No. CN202111172151.1, filed on October 8, 2021 and entitled "Method and Apparatus for Decoding Downlink Control Channel, Storage Medium, and Electronic Apparatus", and claims the priority of the patent invention, which is incorporated in its entirety herein by reference.

**Technical Field**

Embodiments of the invention relate to the field of communication, and in particular to a method and apparatus for decoding a downlink control channel, a storage medium, and an electronic apparatus.

**Background**

In a communication system, a physical downlink control channel (PDCCH) carries downlink control information (DCI) of a physical uplink shared channel (PUSCH) and a physical downlink shared channel (PDSCH). A receiving end detects DCI in a common search space and a dedicated search space in each slot. The DCI detected is used to configure, receive, and decode the PDCCH.

In a 5th generation mobile communication technology new radio (5G NR), the PDCCH is scheduled on the basis of a control-resource-set (CORESET), and a plurality of CORESETs are transmitted in each slot. Each CORESET is composed of a plurality of control channel elements (CCEs). The DCI is carried by the CCE, and one piece of DCI will occupy $2^N$ CCEs (N= 0, 1, 2, 3, or 4). One CCE encompasses 9 resource element groups (REGs). One REG consists of 18 log-likelihood-ratios (LLRs), and each LLR denotes a probability of a bit 0 or 1, or is referred to as a soft information bit.

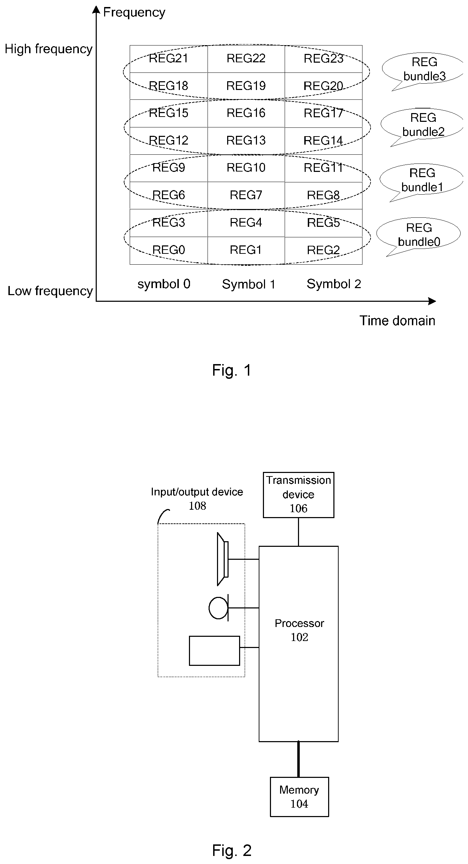

Fig. 1 is a schematic diagram of a transmission format of a CORESET in the related art. As shown in Fig. 1, a vertical axis denotes a frequency domain, and a horizontal axis denotes a time domain. The CORESET is divided into three symbols at most in the time domain, and each symbol occupies the same frequency band resources. One frequency band resource within each symbol can be interpreted as one REG. 2, 3, or 6 REGs constitutes one REG bundle (REGB). PDCCH decoding is to select a data section from a certain start position in the CORESET as candidate decoding data. Whether the data are decoded correctly is verified through a cyclic redundancy check (CRC) and radio network temporary identifier (RNTI) detection on a decoding result. One CORESET encompasses a plurality of candidate decoding data, and a process of decoding and checking a plurality of candidate decoding data is called blind detection of the PDCCH. Each CORESET may initiate blind detection and decoding repeatedly within one slot.

It is required to support multicarrier concurrent blind detection for PDCCH decoding. As specified in the 3rd generation partnership project (3GPP) 5G NR protocol, the PDCCH supports at most 2 carriers to perform DCI blind detection at the same time in a sub 6G scenario, and at most 4 carriers to perform DCI blind detection at the same time in an mmWave scenario. DCI blind detection on each carrier is independent of one another. It is common practice to fix a PDCCH decoding apparatus of each carrier, leading to unsatisfactory configurability and reusability of resources invoked by each carrier. In an actual communication scenario, the amount of transmitted data of each carriers is different. Therefore, flexible configuration and multiplexing of decoding resources are achieved, which is beneficial to improving the ability of a receiving end to cope with a complex scenario and providing more reliable PDCCH decoding performance.

PDCCH decoding takes a slot as a unit, and a plurality of carriers need to be processed in each slot. There are a plurality of control-resource-sets (CORESETs) in each carrier. Each CORESET may have multiple blind detections, and each blind detection may have multiple candidates to be decoded. The log-likelihood-ratio (LLR) will also be processed in the candidate decoding process. Therefore, PDCCH decoding is a multi-layer-nested decoding process. In a control method for a decoding process of a PDCCH nested mode in the related art, with regard to a scenario of multiple CORESETs and multiple blind detection initiation, the decoding processing performance may be reduced.

In view of the control method for a PDCCH nested decoding flow in the related art, it is a pressing issue to provide a solution to the problem that in a control method for a decoding process of a PDCCH nested mode in the related art, with regard to a scenario of multiple CORESETs and multiple blind detection initiation, the decoding processing performance may be reduced.

**Summary**

A method and apparatus for decoding a downlink control channel, a storage medium, and an electronic apparatus are provided in embodiments of the invention. Accordingly, at least the problem that in a control method for a decoding process of a PDCCH nested mode in the related art, with regard to a scenario of multiple CORESETs and multiple blind detection initiation, the decoding processing performance may be reduced is solved.

A method for decoding a downlink control channel is provided in an embodiment of the invention. The method includes:

a resource in a blind detection and decoding process of a physical downlink control channel (PDCCH) is divided into multiple portions of resources;

one or more portions of resources are invoked for a plurality of channels set according to a resource configuration individually, and performing blind detection on data received through the one or more portions of resources; and

invoking one or more PDCCH decoders occupied by the channels to decode candidate decoding data corresponding to the blind detection.

An apparatus for decoding a downlink control channel is provided in another embodiment of the invention. The apparatus includes:

a division module configured to divide a resource in a blind detection and decoding process of a physical downlink control channel (PDCCH) into multiple portions of resources;

a blind detection module configured to invoke one or more portions of resources for a plurality of channels set according to a resource configuration individually, and performing blind detection on data received through the one or more portions of resources; and

a decoding module configured to invoke one or more PDCCH decoders occupied by the channels to decode candidate decoding data corresponding to the blind detection.

A computer-readable storage medium is further provided in yet another embodiment of the invention. The storage medium stores a computer program, where the computer program is configured to execute steps of any one of the above method embodiments when run.

An electronic apparatus is further provided according to still another embodiment of the invention. The electronic apparatus includes a memory and a processor, where the memory stores a computer program, and the processor is configured to execute steps of any one of the above method embodiments when running the computer program.

In the embodiments of the invention, the resource in the blind detection and decoding process of the PDCCH is divided into the plurality of parts; one or more portions of resources are invoked for the plurality of channels set according to a resource configuration individually, and blind detection is performed on data received through the one or more portions of resources; and one or more PDCCH decoders occupied by the channels are invoked to decode candidate decoding data corresponding to the blind detection. Accordingly, the problem that in a control method for a decoding process of a PDCCH nested mode in the related art, with regard to a scenario of multiple CORESETs and multiple blind detection initiation, the decoding processing performance may be reduced can be solved, and a resource amount invoked can be flexibly configured. Moreover, the channels occupied by all carriers can be flexibly configured, and carriers having a large data transmission amount and requiring more resources can be allocated to channels capable of invoking more resources.

## Brief Description of the Drawings

Fig. 1 is a schematic diagram of a transmission format of a control-resource-set (CORESET) in the related art;

Fig. 2 is a structural block diagram of hardware of a mobile terminal of a method for decoding a downlink control channel according to an embodiment of the invention;

Fig. 3 is a flowchart of a method for decoding a downlink control channel according to an embodiment of the invention;

Fig. 4 is a schematic diagram of decoding a physical downlink control channel according to an embodiment of the invention;

Fig. 5 is a flowchart of decoding a physical downlink control channel (PDCCH) according to an embodiment of the invention;

Fig. 6 is a schematic diagram of de-mapping according to an embodiment of the invention;

Fig. 7 is a schematic diagram of de-scrambling, rate de-matching, and sub-block de-interleaving according to an embodiment of the invention;

Fig. 8 is a schematic diagram of rate de-matching according to an embodiment of the invention;

Fig. 9 is a schematic diagram of sub-block de-interleaving according to an embodiment of the invention;

Fig. 10 is a schematic structural diagram of a cyclic redundancy check (CRC) and radio network temporary identifier (RNTI) detection unit according to an embodiment of the invention;

Fig. 11 is a schematic diagram of a CRC and RNTI detection according to an embodiment of the invention; and

Fig. 12 is a block diagram of an apparatus for decoding a downlink control channel according to an embodiment of the invention.

## Detailed Description of the Embodiments

Embodiments of the invention will be described in detail below in conjunction with the accompanying drawings and the embodiments.

It should be noted that the terms "first", "second", etc. in the description and claims of the invention and the above accompanying drawings are used to distinguish between similar objects, instead of necessarily describing a particular sequence or a successive order.

A method embodiment according to the embodiment of the invention may be executed in a mobile terminal, a computer terminal, or a similar computation apparatus. With running on the mobile terminal as an embodiment, Fig. 2 is a structural block diagram of hardware of a mobile terminal of a method for decoding a downlink control channel according to an embodiment of the invention. As shown in Fig. 2, the mobile terminal may include one or more processors 102 (only one processor is shown in Fig. 2, and the processor 102 may include, but is not limited to, a micro programmed control unit (MCU) or a field-programmable gate array (FPGA), etc.) and a memory 104 configured to store data. The above mobile terminal may further include a transmission device 106 configured for a communication function and an input/output device 108. Those of ordinary skill in the art can understand that the structure shown in Fig. 2 is merely illustrative, and does not limit the structure of the above mobile terminal. For embodiment, the mobile terminal may further include more or fewer components than those shown in Fig. 2, or have a configuration differing from that shown in Fig. 2.

The memory 104 may be configured to store a computer program, for embodiment, a software program and a module of application software, such as a computer program corresponding to a method for decoding a downlink control channel in the embodiment of the invention. The processor 102 runs the computer program stored in the memory 104 to execute various function applications and service chain address pool slicing processing, that is, to realize the above method. The memory 104 may include a high-speed random access memory, and may also include a non-volatile memory, such as one or more magnetic storage apparatuses, flashes, or other non-volatile solid-state memories. In some instances, the memory 104 may further include memories remotely configured relative to the processor 102, where these remote memories may be connected with the mobile terminal through a network. The instances of the above network include, but are not limited to, the Internet, an intranet, a local area network, a mobile communication network, and their combinations.

The transmission apparatus 106 is configured to receive or send data via one network. The specific instances of the above network may include a wireless network provided by a communication provider of the mobile terminal. In an instance, the transmission device 106 includes a network interface controller (NIC) that may be connected to other network devices through a base station to communicate with the Internet. In an instance, the transmission apparatus 106 may be a radio frequency (RF) module, which is configured to communicate with the Internet wirelessly.

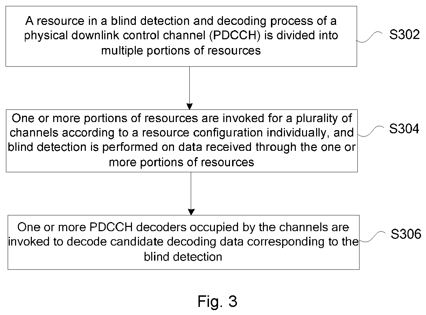

The method for decoding a downlink control channel running on the above mobile terminal or network architecture is provided in the embodiment. Fig. 3 is a flowchart of the method for decoding a downlink control channel according to the embodiment of the invention. As shown in Fig. 3, the flow includes:

S302, a resource in a blind detection and decoding process of a physical downlink control channel (PDCCH) is divided into multiple portions of resources.

The resource in the embodiment of the invention may include a storage resource, a decoding resource, and a parameter resource.

S304, one or more portions of resources are invoked for a plurality of channels according to a resource configuration individually, and blind detection is performed on data received through the one or more portions of resources.

S306, one or more PDCCH decoders occupied by the channels are invoked to decode candidate decoding data corresponding to the blind detection.

The embodiment may be applied to the 5th generation mobile communication technology (5G). Herein 5G is a new generation broadband mobile communication technology with a high speed, low latency, and large bandwidth connection. The International Telecommunication Union has defined three categories application scenarios of 5G, i.e., enhanced mobile broadband (eMBB), ultra reliable low latency communication (uRLLC), and massive machine type communication. Physical downlink control channel decoding is an important loop in the 5G NR communication, and is responsible for completing decoding of the downlink control information. Based on digital circuit hardware, the present invention decodes a physical downlink control channel that supports multicarrier concurrent and is high-performance, stable, and reliable.

Through S302-S306 above, the problem that in a control method for a decoding process of a PDCCH nested mode in the related art, with regard to a scenario of multiple CORESETs and multiple blind detection initiation, the decoding processing performance may be reduced can be solved, and a resource amount invoked can be flexibly configured. Moreover, the channels occupied by all carriers can be flexibly configured, and carriers having a large data transmission amount and requiring more resources can be allocated to channels capable of invoking more resources.

In the embodiment of the invention, in the S304, blind detection is performed on data received through the one or more portions of resources may include: the data are received through a control-resource-set (CORESET), and if the length of the data reaches the length of the blind detection data, the blind detection is performed on the data through the one or more portions of resources. Further, the received data of each CORESET are counted respectively according to a CORESET index input, and the data received are written into a CORESET random access memory (RAM). Blind detection is performed on the CORESET whose data length reaches the length of the blind detection data.

In the embodiment of the invention, the S306 may include:

S3061, the candidate decoding data are read from the CORESET RAM, a resource element group bundle 2 control channel element (REGB2CCE) table is acquired from a hardware-software interface, and CCE indexes are acquired from the REGB2CCE table, where a storage order of the CCE indexes in the REGB2CCE table is consistent with a storage order of REGBs in the CORESET RAM; if the CCE indexes acquired is within a CCE range occupied by the candidate decoding data, a corresponding REGB is determined to belong to the candidate decoding data , where the CCE range occupied by the candidate decoding data is determined through a CCE start index cce_start_index occupied by the candidate decoding data and a number AL of a CCE occupied by the candidate decoding data; an address of the REGB2CCE table is converted to obtain an address for reading the CORESET RAM; and the candidate decoding data are read from the CORESET RAM according to the address.

S3062, de-scrambling, rate de-matching, and sub-block de-interleaving are performed on the candidate decoding data individually, a scrambling code sequence required for performing the de-scrambling on the candidate decoding data is determined according to an initial scrambling code, and the candidate decoding data are subjected to the de-scrambling according to the scrambling code sequence to obtain data subjected to the de-scrambling, where if the scrambling code sequence is zero, the candidate decoding data remain unchanged, and if the scrambling code sequence is 1, the candidate decoding data are inverted and then resulting data are added with 1.

S3063, a rate de-matching type of the candidate decoding data is determined, and the rate de-matching is performed on the data subjected to the de-scrambling according to the determined rate de-matching type to obtain data subjected to the rate de-matching. Further, if the rate de-matching type is shortening rate matching, a positive maximum denoted by a data bit width is added at a tail of the candidate decoding data; if the rate de-matching type is puncturing rate matching zero is added at a header of the candidate decoding data; and if he rate de-matching type is repetition rate matching, data before and after an Nth candidate decoding datum are added together to obtain an addition result, and original 0th-Nth candidate decoding data are replaced with the addition result.

S3064, the sub-block de-interleaving is performed on the data subjected to the rate de-matching, and data subjected to the sub-block de-interleaving are input into a decoder to obtain a plurality of pieces of DCI and corresponding confidence coefficients output by the decoder. Further, the data subjected to the rate de-matching are divided into a plurality of sub-blocks; an order of the plurality of sub-blocks is rearranged, where a relative order of data within the sub-blocks remains unchanged; and the sub-blocks rearranged are stored into a cache of the polar decoder according to an address after the sub-block de-interleaving.

In an embodiment, after the candidate decoding data are subjected to the rate de-matching according to the determined rate de-matching type, the cache of the polar decoder is reused, an address for writing the data received into the cache of the polar decoder is converted into an address after sub-block de-interleaving, and the data received are directly cached into the cache of the polar decoder; and zero, the positive maximum, original data, or the addition result is written into the cache of the polar decoder according to a number of data currently input and the rate de-matching type.

In another embodiment, after the S306, the method further includes: a cyclic redundancy check (CRC) and radio network temporary identifier (RNTI) detection are performed on a plurality of pieces of DCI obtained through decoding, and target DCI is determined from the plurality of pieces of DCI; serial CRC calculation is performed on a plurality of decoding branches individually to obtain a CRC code of DCI output by each decoding branch; exclusive OR processing is performed on the CRC code of the DCI output by each decoding branch and a CRC code output by a corresponding decoding branch to obtain an exclusive OR result; and the target DCI is determined according to the exclusive OR result. Further, if high 8 bits of the exclusive OR result are zero and low 16 bits are consistent with an RNTI value, the decoding branch is determined to be correct upon the CRC and RNTI detection; if the plurality of decoding branches are 8 decoding branches, and only one of the 8 decoding branches is correct upon the CRC and RNTI detection, DCI of the decoding branch is determined as the target DCI; if a plurality of branches of the 8 decoding branches are correct upon the CRC and RNTI detection, DCI of a decoding branch having a lowest confidence coefficient of the plurality of decoding branches is determined as the target DCI; and the target DCI is reported through the hardware-software interface.

In the embodiment, in order to realize flexible configuration and reuse of the decoding resource, the concept of channel is introduced. Herein 4 channels are set, maximum decoding resource amounts that can be invoked by each channel vary, and the resource amounts invoked can be flexibly configured. Moreover, the channels occupied by all carriers can be flexibly configured, and carriers having a large data transmission amount and requiring more resources can be allocated to channels capable of invoking more resources. The storage resource, decoding resource, and parameter resource used in the PDCCH blind detection and decoding process are each divided into 4 parts as well. Each channel may invoke one or more parts of the storage resource, decoding resource, and parameter resource according to the resource configured, so as to cope with various service scenarios.

In order to cope with the complex PDCCH nested decoding flow, the invention employs a hierarchical implementation structure. Therefore, the decoding process is divided into a plurality of levels of slot level-queue level-blind detection initiation level-candidate level-log-likelihood-ratio (LLR) level. Cyclic processing is performed in each level, and processing at each level is performed in an orderly pipelined manner. Accordingly, the decoding process is clearer, and a control flow is more reliable.

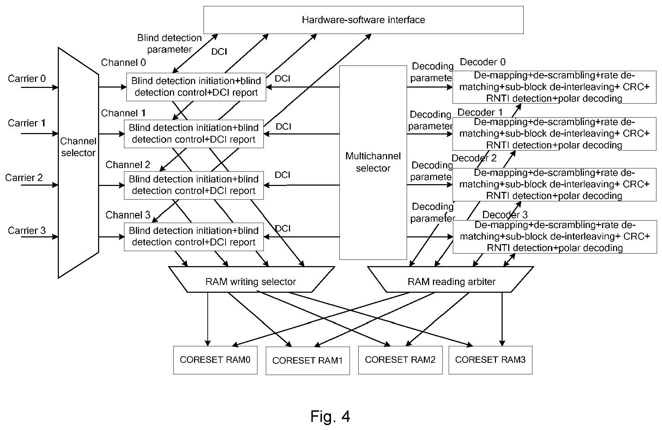

Fig. 4 is a schematic diagram of decoding a physical downlink control channel decoding according to an embodiment of the invention. As shown in Fig. 4, in order to make decoding resource configuration more flexible and decoding performance more perfect and reliable, 4 channels, 4 storage RAMs, and 4 parts of the decoding resource are configured. Each channel may be assigned to a designated carrier for data processing and invoke one or more storage RAMs or one or more parts of the decoding resource. The invention is primarily divided into the following parts, and an entire structure is shown in Fig. 1.

Carrier-to-channel reuse: In the embodiment, decoding capacities of 4 carriers may be configured through software. It is not required for each carrier to simultaneously support invoking of 1-4 parts of the decoding resource configurable. Therefore, the concept of channel (CH) is added, and maximum decoding resource part numbers that can be invoked by different channels vary. CH0 may invoke 1-4 parts, CH1 may invoke 1 part, CH2 may invoke 1-2 parts, and CH3 may invoke 1 part. Data of the 4 carriers may be allocated to any channel for processing.

CORESET storage: In the embodiment, the data received are required to be cached. Data of each blind detection are stored in a corresponding address range according to relevant parameters transmitted through the hardware-software interface, so as to perform subsequent decoding processing. In the invention, 4 CORESET RAMs that are continuously addressed are designed. Addresses of the 4 RAMs are continuous, but one or more RAMs may be invoked by each channel separately. When each channel receives data, the data received by the channel are written into the RAM address range occupied by the channel.

CORESET RAM arbitration reading: One channel may occupy multiple decoding resources, and each part of the decoding resource decodes a plurality of candidate in parallel in one blind detection. Therefore, the plurality of parts of the decoding resource read the same CORESET RAM occupied by the channel simultaneously. To prevent reading conflicts, CORESET RAM arbitration reading is added.

Blind detection initiation and blind detection control: Within one slot, blind detection on the CORESET in each carrier is processed independently. A blind detection initiation module and a blind detection control module are arranged in the channel to independently perform blind detection initiation and blind detection control for each CORESET. The blind detection initiation module detects whether the length of data currently received of the CORESET reaches the data length requirement of the blind detection initiation, and if yes, the blind detection is initiated. The blind detection control module arbitrates the blind detection on each CORESET, and adopts a polling arbitration manner to reduce the priority of the CORESET obtained in the previous arbitration to a lowest level, so as to ensure that blind detections of various CORESETs can be performed in order.

PDCCH decoder: The decoder decodes the plurality of candidate in one blind detection initiation, including de-mapping, de-scrambling, rate de-matching, sub-block de-interleaving, polar decoder invoking, the CRC, the RNTI detection, etc.

Polar decoder: The invention encompasses 8 polar decoders, two of which form one branch as one polar decoder branch to be invoked by the PDCCH decoder.

DCI reporting control: The downlink control information (DCI) decoded by a plurality of PDCCH decoders is arbitrated to determine whether it belongs to the same search-space (SS) and the same CCE start index as DCI reported previously. If yes, DCI having a higher confidence coefficient between the two pieces of DCI is updated to a DCI reporting parameter group. If no, the DCI currently decoded is reported as new DCI.

Hardware-software interface: It is configured to realize software parameters and report hardware decoding results.

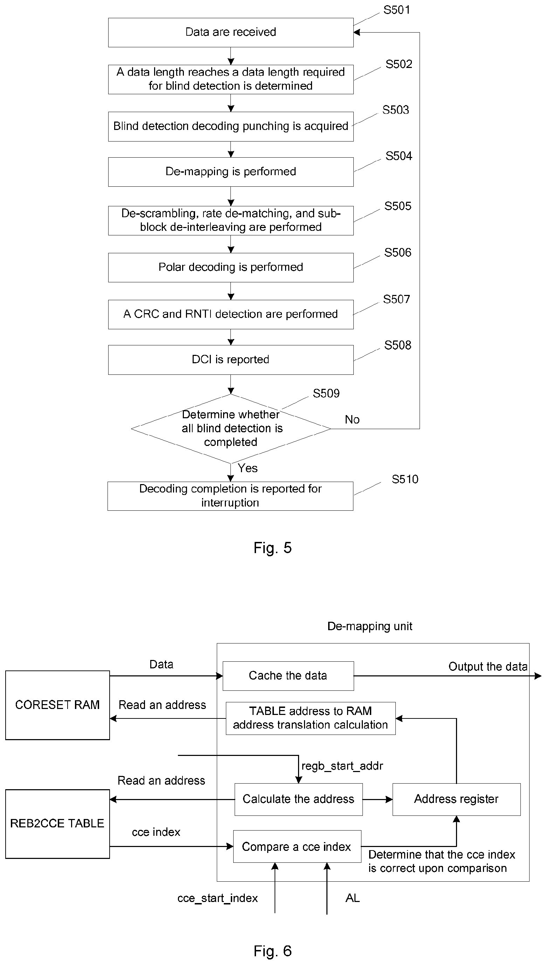

In the embodiment of the invention adopts, the hierarchical structure design is employed, and the PDCCH is decoded according to hierarchical division of slot level-queue level-blind detection initiation level-candidate level-LLR level. Fig. 5 is a flowchart of decoding a PDCCH according to an embodiment of the invention. As shown in Fig. 5, the flow includes:

S501, data are received;

S502, a data length reaches a data length required for blind detection is determined;

S503, blind detection decoding punching is acquired;

S504, de-mapping is performed;

S505, de-scrambling, rate de-matching, and sub-block de-interleaving are performed;

S506, polar decoding is performed;

S507, a CRC and RNTI detection are performed;

S508, DCI is reported;

S509, determine whether all blind detection is completed, if yes, S510 is executed, otherwise S501 is returned; and

S510, decoding completion is reported for interruption.

The embodiment is primarily divided into three parts: blind detection initiation and control, blind detection and decoding, and DCI reporting. Each part is described in detail below.

In the embodiment, for the blind detection initiation and control link, one blind detection initiation and control unit is arranged in each channel and is responsible for initiating multiple blind detection on the plurality of CORESETs and controlling a decoding order of each blind detection. The blind detection initiation and control unit initiates the blind detection on each CORESET independently, counts the data received by each CORESET according to a CORESET index input separately, and writes the data received into the CORESET RAM. When the length of the data received by a certain CORESET reaches the data length required for blind detection, one blind detection on the CORESET is initiated. The data length required for blind detection herein is calculated through the parameter $n\_rb \times n\_symbol$, indicating a number of data encompassed in the CORESET during the blind detection.

The data are stored in the CORESET RAM before each blind detection on each CORESET is initiated. The start storage address is determined through the parameter reg_start_addr. In a de-mapping unit, the data stored are read out to decode the PDCCH.

Since one channel receives the data from the plurality of CORESETs, it is required to arbitrate the blind detection initiation for each CORESET. The CORESET arbitrated invokes one or more PDCCH decoders occupied by the channel to decode the candidate corresponding to the blind detection. One blind detection may decode the plurality of candidate, and one PDCCH decoder can decode only one candidate at a time.

The PDCCH decoding link is to decode the candidate in the blind detection, which is jointly completed by a de-mapping unit, a de-scrambling unit, a rate de-matching unit, and a sub-block de-interleaving unit.

Fig. 6 is a schematic diagram of de-mapping according to an embodiment of the invention. As shown in Fig. 6, the de-mapping unit is responsible for reading the data encompassed in the candidate from the CORESET RAM, so that the subsequent processing units perform a series of processing on the data. The de-mapping unit acquires one REGB2CCE table from the hardware-software interface, where the CCE index is stored in the table. A storage order of the CCE indexes in the table is the same as a storage order of REGBs in the CORESET RAM. Accordingly, whether a corresponding REGB belongs to the candidate can be determined by confirming whether the CCE index is within the CCE range occupied by the candidate. The CCE range occupied by the candidate may be determined through two parameters, cce_start_index and AL, and the range is cce_start_index~cce_start_index+ AL. The de-mapping unit reads the REGB2CCE table from regb_start_addr, i.e., a start address for reading the REGB2CCE table during the blind detection, traverses the table to locate the CCE index belonging to the candidate, and caches the storage address of the CCE index in the REGB2CCE table.

Some parameters used in the embodiment are configured for hardware through the hardware-software interface. Channel parameters are shown in Table 1, blind detection initiation parameters are shown in Table 2, and blind detection candidate parameters are shown in Table 3.

Table 1

| Parameter name | Meaning |
|---|---|
| n_symbol | A number of symbols encompassed in the CORESET and received by the channel |
| dci_size | A DCI length reported by the channel |
| rnits | The RNTI value used by the channel for RNTI detection |

Table 2

| Parameter name | Meaning |
|---|---|
| n_rb | A number of resource block (RB) frequency band resources encompassed in each symbol of the CORESET |
| n_symbol | A number of symbol encompassed in the CORESET |
| reg_start_addr | The start address for storing the data received in the CORESET RAM during the blind detection on the CORESET |
| regb_start_addr | The start address for reading the REGB2CCE table during the blind detection on the CORESET |
| n_cand | A number of candidate to be decoded during the blind detection on the CORESET |
| n_cand_start | The start index of the candidate to be decoded during the blind detection on the CORESET |
| start_times | A number of blind detection initiated for the CORESET |

Table 3

| Parameter name | Meaning |
|---|---|
| rm_type | The rate de-matching type (puncturing, shortening, or repetition) employed for decoding the candidate |
| N | The data length after rate de-matching |
| AL | A number of CCEs occupied by the candidate |
| cce_start_index | The start index of CCEs occupied by the candidate |

In order to acquire the address for reading the CORESET RAM, the address of the REGB2CCE table is also required to be converted and calculated. A calculation formula is as follows:

$$ram\_addr = reg\_start\_addr + n\_symbol*symbol\_rb + regb\_rb*table\_addr + rb\_offset$$

The right side of the equation is divided into 4 items. The first item reg_start_addr indicates the start address for reading the CORESET RAM for this blind detection.

The second item n_symbol*symbol_rb indicates a number of RBs encompassed in one symbol. As can be seen from the data resource transmission format of the PDCCH that the REGBs in each symbol are arranged in the same manner. Therefore, the order of the corresponding CCE indexes is also the same. The data are received in the symbol order, and the correspondence relations between the REGBs and the CCEs in the first symbol are the same. Therefore, an address for reading the CORESET RAM of the second symbol may be obtained by utilizing table_addr

8

for calculation on the basis of the address of the first symbol.

In the third item regb_rb*table_addr, regb_rb indicates a number of RBs encompassed in one REGB. Since the REGB corresponds to the CCE in the REGB2CCE table, the REG (corresponding to one RB) is stored in each unit of the CORESET RAM. Therefore, when table_addr is used to calculate the address for reading the CORESET RAM, it is required to multiply table_addr by a number of RBs encompassed in the REGB.

The fourth item rb_offset indicates the offset in the current REGB and which REG corresponding to the RB in the CORESET RAM is read.

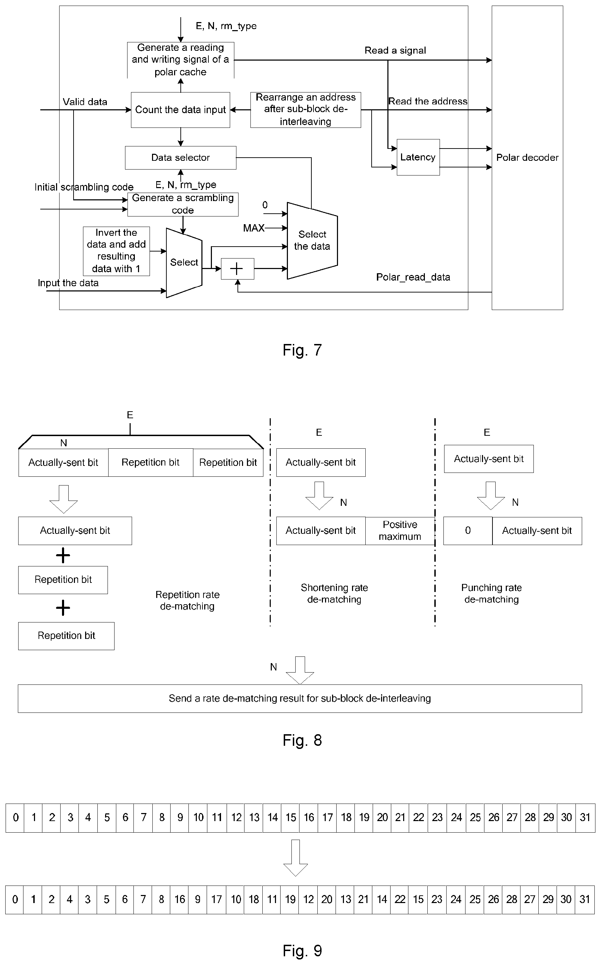

Fig. 7 is a schematic diagram of de-scrambling, rate de-matching, and sub-block de-interleaving according to an embodiment of the invention. As shown in Fig. 7, three decoding steps of de-scrambling, rate de-matching, and sub-block de-interleaving are implemented in one unit. Therefore, the three decoding steps may be processed in a pipelined manner, so that the processing latency is reduced. The three decoding operations of de-scrambling, rate de-matching, and sub-block de-interleaving are completed in the unit.

De-scrambling is to calculate a scrambling code sequence required for performing the de-scrambling according to initial scrambling code, and realize online calculation according to a number of data input. When one data set is input, a corresponding scrambling code sequence will be calculated to complete the scrambling code calculation. If the scrambling code sequence is zero, corresponding data remain unchanged. If the scrambling code sequence is 1, the data are inverted, and resulting data are added with 1.

Fig. 8 is a schematic diagram of rate de-matching according to an embodiment of the invention. As shown in Fig. 8, rate de-matching is divided into three types: shortening, puncturing, and repetition. The unit determines a way to execute rate de-matching according to rm_type configured for the hardware-software interface. For shortening rate matching, it is required to add a positive maximum denoted by a data bit width at a tail of the data input. For puncturing rate matching, it is required to add zero at a header of data input. For repetition rate matching, it is required to add data before and after an Nth datum to obtain new data, so as to replace original 0th-Nth data input.

It is required to cache first N input data for repetition rate matching, so as to add the data and subsequent input data together for repetition rate matching. Therefore, the unit reuses the cache inside the polar decoder and caches the data received directly into a polar data cache. The unit determines whether to write zero, the positive maximum, the original data, or the addition result to the polar data cache according to the number of data currently input and the rate de-matching type.

Fig. 9 is a schematic diagram of sub-block de-interleaving according to an embodiment of the invention. As shown in Fig. 9, sub-block de-interleaving is to divide data subjected to the rate de-matching into 32 sub-blocks, rearrange an order of the sub-blocks, and remain a relative order of the data in the sub-blocks unchanged. In the unit, during rate de-matching, the address of the input data written into the polar cache is directly converted online into the address after the sub-block de-interleaving, and then is written into the polar data cache. Such a method combines rate de-matching and sub-block de-interleaving, thereby reducing the latency of data processing.

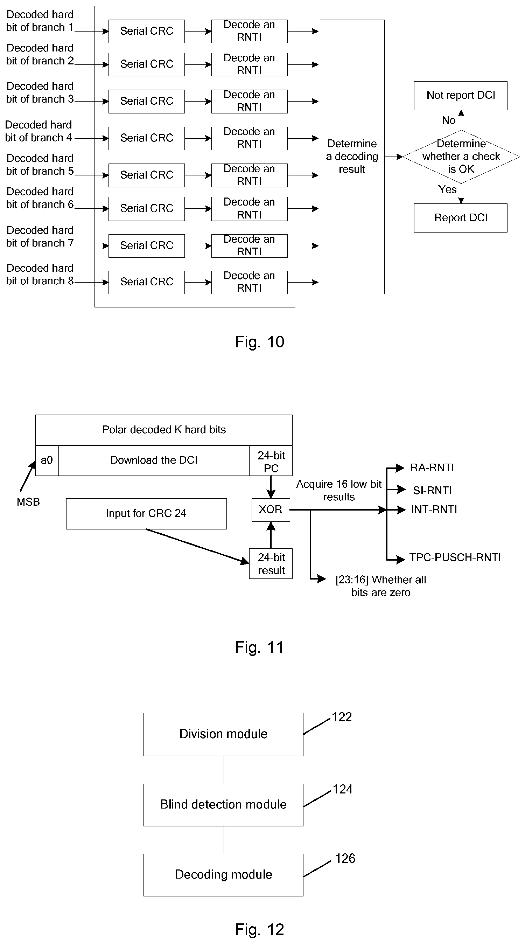

Fig. 10 is a schematic structural diagram of a CRC and RNTI detection unit according to an embodiment of the invention. As shown in Fig. 10, the CRC and RNTI detection unit sends soft bit information, log-likelihood-ratio (LLR) after de-scrambling, rate de-matching, and sub-block de-interleaving into the polar decoder for decoding to obtain a hard bit sequence after decoding.

Fig. 11 is a schematic diagram of a CRC and RNTI detection according to an embodiment of the invention. As shown in Fig. 11, the CRC and RNTI detection unit performs the CRC and RNTI detection on the hard bit sequence output. The polar decoder used in the embodiment outputs decoding information of the 8 branches. The decoding information of each branch has a corresponding confidence coefficient to represent the reliability of the decoding information of the branch. The structure of the CRC and RNTI detection unit is shown in Fig. 9.

In the unit, the serial CRC calculation is performed on the 8 decoding branches individually to calculate a CRC code of an information bit sequence output by the branch, and then exclusive OR is performed on the CRC code output by the branch. If the high 8bit of the exclusive OR result is 0 and the low 16 bits is consistent with the RNTI value, it indicates that both the CRC checksum and the RNTI detection are correct. If the plurality of branches are correct upon the CRC and RNTI detection, branch information having a most reliable confidence coefficient is reported.

In a DCI reporting link, the DCI finally acquired after decoding is transmitted to the hardware-software interface. Software acquires the DCI acquired by decoding a hardware digital circuit through the hardware-software interface. Since a blind detection method is employed in PDCCH decoding, the plurality of candidate decoding data are decoded during one blind detection initiation, and the plurality of pieces of DCI are finally decoded. As can be seen from related protocols that in the same blind detection, if the start positions of two candidate decoding data section are the same, only one of the two candidate decoding data is required to be reported. In the invention, DCI having the same cce_start_index in the same blind detection initiation is compared, and DCI having a more reliable confidence coefficient between the two pieces of the DCI is taken as a finally-reported result.

An apparatus for decoding a downlink control channel is further provided in another embodiment of the invention. Fig. 12 is a block diagram of the apparatus for decoding a downlink control channel according to the embodiment of the invention. As shown in Fig. 12, the apparatus includes:

a division module 122 configured to divide a resource in a blind detection and decoding process of a physical downlink control channel (PDCCH) into a plurality of parts;

a blind detection module 124 configured to invoke one or more portions of resources for a plurality of channels set according to a resource configuration individually, and perform blind detection on data received through the one or more portions of resources; and

a decoding module 126 configured to invoke one or more PDCCH decoders occupied by the channels to decode candidate decoding data corresponding to the blind detection.

In an illustrative embodiment, the blind detection module 124 is further configured to:
receive the data through a control-resource-set (CORESET), and when the length of the data reaches the length of blind detection data, perform the blind detection on the data through the one or more portions of resources.
In an illustrative embodiment, the blind detection module 124 includes:

a counting submodule configured to count data received through each CORESET respectively according to a CORESET index input, and write the data received into a CORESET RAM; and

a blind detection submodule configured to perform blind detection on the CORESET whose data length reaches the blind detection data length.

In an illustrative embodiment, the decoding module 126 includes:

a reading submodule configured to read the candidate decoding data from the CORESET RAM; and

a processing submodule configured to perform de-scrambling, rate de-matching, and sub-block de-interleaving on the candidate decoding data individually.

In an illustrative embodiment, the reading submodule is further configured to

acquire a REGB2CCE table from a hardware-software interface, and acquire CCE indexes from the REGB2CCE table, where a storage order of the CCE indexes in the REGB2CCE table is consistent with a storage order of REGBs in the CORESET RAM;

when the CCE indexes acquired is within a CCE range occupied by the candidate decoding data, determine that a corresponding REGB belongs to the candidate decoding data, where the CCE range occupied by the candidate decoding data is determined through a CCE start index cce_start_index occupied by the candidate decoding data and a number AL of a CCE occupied by the candidate decoding data;

convert an address of the REGB2CCE table to obtain an address for reading the CORESET RAM; and

read the candidate decoding data from the CORESET RAM according to the address.

In an illustrative embodiment, the processing submodule includes:

a de-scrambling unit configured to determine a scrambling code sequence required for performing de-scrambling on the candidate decoding data according to an initial scrambling code, and perform the de-scrambling on the candidate decoding data according to the scrambling code sequence to obtain data subjected to the de-scrambling, where in response to determining that the scrambling code sequence is zero, the candidate decoding data remain unchanged, and in response to determining that the scrambling code sequence is 1, the candidate decoding data are inverted, and then resulting data are added with 1;

a rate de-matching unit configured to determine a rate de-matching type of the candidate decoding data, and perform rate de-matching on the data subjected to the de-scrambling according to the determined rate de-matching type to obtain data subjected to the rate de-matching; and

a sub-block de-interleaving unit configured to perform sub-block de-interleaving on the data subjected to the rate de-matching, and input data subjected to the sub-block de-interleaving into a decoder to obtain a plurality of pieces of DCI and corresponding confidence coefficients output by the decoder.

In an illustrative embodiment, the rate de-matching unit is further configured to:

when the rate de-matching type is shortening rate matching, add a positive maximum denoted by a data bit width at a tail of the candidate decoding data;

when the rate de-matching type is puncturing rate matching, add zero at a header of the candidate decoding data; and

when the rate de-matching type is repetition rate matching, add data before and after an Nth candidate decoding datum together to obtain an addition result, and replace original Oth-Nth candidate decoding data with the addition result.

In an illustrative embodiment, the apparatus further includes:

a cache module configured to reuse a cache of a polar decoder, convert an address for writing the data received into the cache of the polar decoder into an address after sub-block de-interleaving, and directly cache the data received into the cache of the polar decoder; and

a writing-in module configured to write zero, the positive maximum, original data, or the addition result into the cache of the polar decoder according to a number of data currently input and the rate de-matching type.

In an illustrative embodiment, the sub-block de-interleaving unit is further configured to:

divide the data subjected to the rate de-matching into a plurality of sub-blocks;

rearrange an order of the plurality of sub-blocks, where a relative order of data within the sub-blocks remains unchanged; and

store the sub-blocks rearranged into the cache of the polar decoder according to the address after the sub-block de-interleaving.

In an illustrative embodiment, the apparatus further includes:

a determination module configured to perform a CRC and RNTI detection on a plurality of pieces of DCI obtained through decoding, and determine target DCI from the plurality of pieces of DCI; and

a report module configured to report the target DCI through the hardware-software interface.

In an illustrative embodiment, the determination module includes:

a calculation submodule configured to perform serial CRC calculation on a plurality of decoding branches individually to obtain a CRC code of DCI output by each decoding branch;

an exclusive OR submodule configured to perform exclusive OR processing on the CRC code of the DCI output by each decoding branch and a CRC code output by a corresponding decoding branch to obtain an exclusive OR result; and

a determination submodule configured to determine the target DCI according to the exclusive OR result.

In an illustrative embodiment, the determination submodule is further configured to:

when high 8 bits of the exclusive OR result are zero and low 16 bits are consistent with an RNTI value, determine that the decoding branch is correct upon the CRC and RNTI detection;

when the plurality of decoding branches are 8 decoding branches and only one of the 8 decoding branches is correct upon the CRC and RNTI detection, determine DCI of the decoding branch as the target DCI; and

when a plurality of branches of the 8 decoding branches are correct upon the CRC and RNTI detection, determine DCI of a decoding branch having a lowest confidence coefficient of the plurality of decoding branches as the target DCI.

A computer readable storage medium is further provided in an embodiment of the invention. The computer readable storage medium stores a computer program, where the computer program is configured to perform, when executed by a processor, steps of any one of the above method embodiments.

In an illustrative embodiment, the above computer readable storage media may include, but are not limit to, various media storing a computer program, such as a universal serial bus (USB) flash disk, a read-only memory (ROM), a random access memory (RAM), a mobile hard disk, a magnetic disk or an optical disk, etc.

An electronic apparatus is further provided in an embodiment of the invention. The electronic apparatus includes a memory and a processor, where the memory stores a computer program, and the processor is configured to execute steps of any one of the above method embodiments when running the computer program.

In an illustrative embodiment, the above electronic apparatus may further include a transmission device and an input/output device, where the transmission device and the input/output device are connected to the above processor.

Reference may be made to the instances described in the above embodiments and the illustrative embodiments for the specific instances in the embodiment, which will not be repeated herein.

Apparently, those skilled in the art should understand that all the modules or steps above of the invention can be implemented through a general-purpose computation apparatus, centralized on a single computation apparatus or distributed over a network composed of a plurality of computation apparatuses, and implemented through program codes executable by the computation apparatus. Therefore, the modules or steps can be stored in a storage apparatus to be executed by the computation apparatus. In some cases, the steps shown or described can be executed in a different order from herein. Alternatively, some or all of the modules or the steps can be implemented by fabricating same into individual integrated circuit modules separately. In this way, the invention is not limited to any particular combination of hardware and software.

What are described above are merely the preferred embodiments of the invention, and are not intended to limit the invention. Those skilled in the art can make various modifications and variations to the invention. Any modifications, equivalent replacements, improvements, etc. made within the principles of the invention should fall within the scope of protection of the invention.

## Claims

1. A method for decoding a downlink control channel, comprising:

    dividing a resource in a blind detection and decoding process of a physical downlink control channel, PDCCH, into multiple portions of resources;
    invoking one or more portions of resources for a plurality of channels set according to a resource configuration individually, and performing blind detection on data received through the one or more portions of resources; and
    invoking one or more PDCCH decoders occupied by the channels to decode candidate decoding data corresponding to the blind detection.

2. The method according to claim 1, wherein the performing blind detection on data received through the one or more portions of resources comprises:
    receiving the data through a control-resource-set, CORESET, and when the length of the data reaches the length of blind detection data, performing the blind detection on the data through the one or more portions of resources.

3. The method according to claim 2, wherein the receiving the data through a CORESET, and when the length of the data reaches the length of blind detection data, performing the blind detection on the data through the one or more portions of resources comprise:

    counting data received through each CORESET respectively according to a CORESET index input, and writing the data received into a CORESET random access memory, RAM; and
    performing blind detection on the CORESET whose data length reaches the blind detection data length.

4. The method according to claim 3, wherein the invoking one or more PDCCH decoders occupied by the channels to decode candidate decoding data corresponding to the blind detection comprises:

> reading the candidate decoding data from the CORESET RAM; and
> performing de-scrambling, rate de-matching, and sub-block de-interleaving on the candidate decoding data individually.

**5.** The method according to claim 4, wherein the reading the candidate decoding data from the CORESET RAM comprises:

> acquiring a resource element group bundle 2 control channel element ,REGB2CCE, table from a hardware-software interface, and acquiring CCE indexes from the REGB2CCE table, wherein a storage order of the CCE indexes in the REGB2CCE table is consistent with a storage order of REGBs in the CORESET RAM;
> when the CCE index acquired is within a CCE range occupied by the candidate decoding data, determining that a corresponding REGB belongs to the candidate decoding data, wherein the CCE range occupied by the candidate decoding data is determined through a CCE start index cce_start_index occupied by the candidate decoding data and a number AL of a CCE occupied by the candidate decoding data;
> converting an address of the REGB2CCE table to obtain an address for reading the CORESET RAM; and
> reading the candidate decoding data from the CORESET RAM according to the address.

**6.** The method according to claim 4, wherein the performing de-scrambling, de-rate matching, and sub-block de-interleaving on the candidate decoding data individually comprises:

> determining a scrambling code sequence required for performing the de-scrambling on the candidate decoding data according to an initial scrambling code, and performing the de-scrambling on the candidate decoding data according to the scrambling code sequence to obtain data subjected to the de-scrambling, when the scrambling code sequence is zero, the candidate decoding data remain unchanged, and when the scrambling code sequence is 1, the candidate decoding data are inverted and then resulting data are added with 1;
> determining a rate de-matching type of the candidate decoding data, and performing the rate de-matching on the data subjected to the de-scrambling according to the determined rate de-matching type to obtain data subjected to the rate de-matching; and
> performing the sub-block de-interleaving on the data subjected to the rate de-matching, and inputting data subjected to the sub-block de-interleaving into a decoder to obtain a plurality of pieces of downlink control information DCI, and corresponding confidence coefficients output by the decoder.

**7.** The method according to claim 6, wherein the performing the rate de-matching on the candidate decoding data according to the determined rate de-matching type comprises:

> when the rate de-matching type is shortening rate matching, adding a positive maximum denoted by a data bit width at a tail of the candidate decoding data ;
> when the rate de-matching type is puncturing rate matching, adding zero at a header of the candidate decoding data; and
> when the rate de-matching type is repetition rate matching, adding data before and after an Nth candidate decoding datum together to obtain an addition result, and replacing original Oth-Nth candidate decoding data with the addition result.

**8.** The method according to claim 7, wherein after performing the rate de-matching on the candidate decoding data according to the determined rate de-matching type, the method further comprises:

> reusing a cache of a polar decoder, converting an address for writing the data received into the cache of the polar decoder into an address after sub-block de-interleaving, and directly caching the data received into the cache of the polar decoder; and
> writing zero, the positive maximum, original data, or the addition result into the cache of the polar decoder according to a number of data currently input and the rate de-matching type.

**9.** The method according to claim 7, wherein the performing sub-block de-interleaving on the data subjected to the rate de-matching to obtain a plurality of pieces of DCI comprises:

> dividing the data subjected to the rate de-matching into a plurality of sub-blocks;

rearranging an order of the plurality of sub-blocks, wherein a relative order of data within the sub-blocks remains unchanged; and

storing the sub-blocks rearranged into a cache of a polar decoder according to an address after the sub-block de-interleaving.

10. The method according to any one of claims 1-9, wherein after the invoking one or more PDCCH decoders occupied by the channels to decode candidate decoding data corresponding to the blind detection, the method further comprises:

performing a cyclic redundancy check, CRC, and radio network temporary identifier, RNTI, detection on the plurality of pieces of DCI obtained through decoding, and determining target DCI from the plurality of pieces of DCI; and

reporting the target DCI through the hardware-software interface.

11. The method according to claim 10, wherein the performing a CRC and RNTI detection on the plurality of pieces of DCI obtained through decoding, and determining target DCI from the plurality of pieces of DCI comprise:

performing serial CRC calculation on a plurality of decoding branches individually to obtain a CRC code of DCI output by each decoding branch;

performing exclusive OR processing on the CRC code of the DCI output by each decoding branch and a CRC code output by a corresponding decoding branch to obtain an exclusive OR result; and

determining the target DCI according to the exclusive OR result.

12. The method according to claim 11, wherein the determining the target DCI according to the exclusive OR result comprises:

when high 8 bits of the exclusive OR result are zero and low 16 bits are consistent with an RNTI value, determining that the CRC and RNTI detection are correct;

when the plurality of decoding branches are 8 decoding branches and only one of the 8 decoding branches is correct upon the CRC and RNTI detection, determining DCI of the decoding branch as the target DCI; and

when a plurality of branches of the 8 decoding branches are correct upon the CRC and RNTI detection, determining DCI of a decoding branch having a lowest confidence coefficient of the plurality of decoding branches as the target DCI.

13. An apparatus for decoding a downlink control channel, comprising:

a division module configured to divide a resource in a blind detection and decoding process of a physical downlink control channel PDCCH, into multiple portions of resources;

a blind detection module configured to invoke one or more portions of resources for a plurality of channels set according to a resource configuration individually, and performing blind detection on data received through the one or more portions of resources; and

a decoding module configured to invoke one or more PDCCH decoders occupied by the channels to decode candidate decoding data corresponding to the blind detection.

14. A computer readable storage medium, wherein a computer program is stored in the computer readable storage medium , and the computer program is configured to cause, when executed by a processor, the processor to perform the method as claimed in any one of claims 1-12.

15. An electronic apparatus, comprising a memory and a processor, and a computer program that is stored in the memory and executable on the processor, wherein the processor is configured to execute the computer program to perform the method as claimed in any one of claims 1-12.

Fig. 1

Fig. 2

A resource in a blind detection and decoding process of a physical downlink control channel (PDCCH) is divided into multiple portions of resources — S302

One or more portions of resources are invoked for a plurality of channels according to a resource configuration individually, and blind detection is performed on data received through the one or more portions of resources — S304

One or more PDCCH decoders occupied by the channels are invoked to decode candidate decoding data corresponding to the blind detection — S306

Fig. 3

| Hardware-software interface |
| --- |

Blind detection parameter  DCI

Carrier 0

Channel 0

Blind detection initiation+blind detection control+DCI report

DCI

Decoding parameter

Decoder 0

De-mapping+de-scrambling+rate de-matching+sub-block de-interleaving+ CRC+ RNTI detection+polar decoding

Carrier 1

Channel 1

Blind detection initiation+blind detection control+DCI report

DCI

Decoding parameter

Decoder 1

De-mapping+de-scrambling+rate de-matching+sub-block de-interleaving+ CRC+ RNTI detection+polar decoding

Channel selector

Multichannel selector

Carrier 2

Channel 2

Blind detection initiation+blind detection control+DCI report

DCI

Decoding parameter

Decoder 2

De-mapping+de-scrambling+rate de-matching+sub-block de-interleaving+ CRC+ RNTI detection+polar decoding

Carrier 3

Channel 3

Blind detection initiation+blind detection control+DCI report

DCI

Decoding parameter

Decoder 3

De-mapping+de-scrambling+rate de-matching+sub-block de-interleaving+ CRC+ RNTI detection+polar decoding

| RAM writing selector | RAM reading arbiter |
| --- | --- |

| CORESET RAM0 | CORESET RAM1 | CORESET RAM2 | CORESET RAM3 |
| --- | --- | --- | --- |

Fig. 4

S501

Data are received

S502

A data length reaches a data length required for blind detection is determined

S503

Blind detection decoding punching is acquired

S504

De-mapping is performed

S505

De-scrambling, rate de-matching, and sub-block de-interleaving are performed

S506

Polar decoding is performed

S507

A CRC and RNTI detection are performed

S508

DCI is reported

S509

Determine whether all blind detection is completed

No

Yes

S510

Decoding completion is reported for interruption

Fig. 5

De-mapping unit

CORESET RAM

Data

Cache the data

Output the data

Read an address

TABLE address to RAM address translation calculation

regb_start_addr

Read an address

Calculate the address

Address register

REB2CCE TABLE

cce index

Compare a cce index

Determine that the cce index is correct upon comparison

cce_start_index

AL

Fig. 6

Fig. 7

Fig. 8

Fig. 9

Decoded hard bit of branch 1 → Serial CRC → Decode an RNTI →

Decoded hard bit of branch 2 → Serial CRC → Decode an RNTI →

Decoded hard bit of branch 3 → Serial CRC → Decode an RNTI →

Decoded hard bit of branch 4 → Serial CRC → Decode an RNTI →

Decoded hard bit of branch 5 → Serial CRC → Decode an RNTI →

Decoded hard bit of branch 6 → Serial CRC → Decode an RNTI →

Decoded hard bit of branch 7 → Serial CRC → Decode an RNTI →

Decoded hard bit of branch 8 → Serial CRC → Decode an RNTI →

Determine a decoding result

Not report DCI

No

Determine whether a check is OK

Yes

Report DCI

**Fig. 10**

Polar decoded K hard bits

| a0 | Download the DCI | 24-bit PC |

MSB

Input for CRC 24

XOR

24-bit result

Acquire 16 low bit results

RA-RNTI

SI-RNTI

INT-RNTI

TPC-PUSCH-RNTI

[23:16] Whether all bits are zero

**Fig. 11**

Division module ⟋ 122

Blind detection module ⟋ 124

Decoding module ⟋ 126

**Fig. 12**

## INTERNATIONAL SEARCH REPORT

| International application No. |
|---|
| **PCT/CN2022/122236** |

**A.    CLASSIFICATION OF SUBJECT MATTER**

H04W 72/04(2009.01)i

According to International Patent Classification (IPC) or to both national classification and IPC

**B.    FIELDS SEARCHED**

Minimum documentation searched (classification system followed by classification symbols)

H04W72/-

Documentation searched other than minimum documentation to the extent that such documents are included in the fields searched

Electronic data base consulted during the international search (name of data base and, where practicable, search terms used)

CNABS; CNTXT; WPABSC; WPABS; ENTXTC; CNKI: 物理下行控制信道, PDCCH, 资源池, 资源集合, 通道, 资源, 参数, 盲检, 解码 VEN; WPABS; ENTXT; 3GPP: PDCCH, resource, pool, set, channel, parameter, blind, detect, decode

**C.    DOCUMENTS CONSIDERED TO BE RELEVANT**

| Category* | Citation of document, with indication, where appropriate, of the relevant passages | Relevant to claim No. |
|---|---|---|
| X | CN 110138502 A (HUAWEI TECHNOLOGIES CO., LTD.) 16 August 2019 (2019-08-16) description, paragraphs 125, 126, 131, 133, 136, 138-141, and 144 | 1-15 |
| A | CN 111680467 A (CHONGQING UNIVERSITY OF POSTS AND TELECOMMUNICATIONS) 18 September 2020 (2020-09-18) entire document | 1-15 |
| A | CN 109151833 A (HUAWEI TECHNOLOGIES CO., LTD.) 04 January 2019 (2019-01-04) entire document | 1-15 |
| A | WO 2020040266 A1 (SHARP K. K.) 27 February 2020 (2020-02-27) entire document | 1-15 |

☐ Further documents are listed in the continuation of Box C.        ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **11 November 2022** | **20 December 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2022/122236**

| Patent document cited in search report | | | Publication date (day/month/year) | Patent family member(s) | | | Publication date (day/month/year) |
|---|---|---|---|---|---|---|---|
| CN | 110138502 | A | 16 August 2019 | CN | 110138502 | B | 07 August 2020 |
| CN | 111680467 | A | 18 September 2020 | None | | | |
| CN | 109151833 | A | 04 January 2019 | WO | 2018228529 | A1 | 20 December 2018 |
| | | | | EP | 3637821 | A1 | 15 April 2020 |
| | | | | US | 2020120720 | A1 | 16 April 2020 |
| | | | | BR | 112019026687 | A2 | 23 June 2020 |
| | | | | IN | 202047000687 | A | 17 January 2020 |
| | | | | EP | 3637821 | A4 | 17 June 2020 |
| | | | | CN | 109151833 | B | 21 July 2020 |
| WO | 2020040266 | A1 | 27 February 2020 | JP | 2020031322 | A | 27 February 2020 |

Form PCT/ISA/210 (patent family annex) (January 2015)

**EP 4 401 489 A1**

**Patent documents cited in the description**

- CN 202111172151